# EUROPEAN PATENT APPLICATION

(11) **EP 3 089 359 A1**
(43) Date of publication of application: **02.11.2016**
(21) Application number: 14874225.7
(22) Date of filing: 19.06.2014
(51) Int. Cl.: H03F 1/07, H03F 3/24

(54) **POWER AMPLIFYING APPARATUS AND METHOD FOR CONTROLLING POWER AMPLIFYING APPARATUS**

(30) Priority: 26.12.2013 JP 2013270261
(71) Applicant: Kabushiki Kaisha Toshiba, Minato-ku Tokyo 105-8001 (JP)
(72) Inventor: ITAGAKI Hiromu, Tokyo 105-8001 (JP); OTSUKI Shunya, Tokyo 105-8001 (JP)
(74) Representative: Hoffmann Eitle
(86) International application number: PCT/JP2014/066326
(87) International publication number: WO 2015/098149

(57) **Abstract**

A power amplifying apparatus of an embodiment includes a Doherty amplifier, a voltage adjuster, and a central processing unit. The Doherty amplifier is configured to amplify an input signal using a main amplifier and a peak amplifier and outputs an output signal in which the amplified signals are synthesized. The voltage adjuster is configured to supply drain voltages and gate voltages to the main amplifier and the peak amplifier. The central processing unit performs, based on a ratio between a saturated output power and an average output power of the Doherty amplifier, a control of the voltage adjuster to supply the drain voltages and the gate voltages.

## Description

### Technical Field

Embodiments of the present invention relate to a power amplifying apparatus and a method for controlling a power amplifying apparatus.

### Background Art

Conventionally, a Doherty amplifier that combines a main amplifier with a peak amplifier has been used as a power amplifying apparatus to amplify input power with high efficiency. When using a power amplifying apparatus, for example in terrestrial digital television transmission, the modulation scheme, such as ISDB-T, DVB, ATSC, will differ, depending upon the region of use. For this reason, the ratio between the saturated power level and the average power level (PAR: peak-to-average ratio) required by the power amplifying apparatus will differ over a range of, for example, 6 to 10 dB between the above-noted modulation schemes.

However, conventionally, by using a power amplifying apparatus that has a fixed PAR for the maximum power efficiency, there have been cases in which the power efficiency decreases.

### Citation List

### Patent Literature

[Patent Literature 1] Japanese Patent Application Laid-Open Publication No. 2007-81800
[Patent Literature 2] Japanese Patent Application Laid-Open Publication No. 2010-34954
[Patent Literature 3] Japanese Patent Application Laid-Open Publication No. 2010-114539

### Summary of Invention

### Technical Problem

The problem the present invention seeks to solve is that of providing a power amplifying apparatus and a method for controlling a power amplifying apparatus capable of maintain a high power efficiency even when amplifying input signals having different modulation schemes.

### Solution to Problem

A power amplifying apparatus of an embodiment includes a Doherty amplifier, a voltage adjuster, and a central processing unit. The Doherty amplifier is configured to amplify an input signal using a main amplifier and a peak amplifier and outputs an output signal in which the amplified signals are synthesized. The voltage adjuster is configured to supply drain voltages and gate voltages to the main amplifier and the peak amplifier. The central processing unit performs, based on a ratio between a saturated output power and an average output power of the Doherty amplifier, a control of the voltage adjuster to supply the drain voltages and the gate voltages.

### Brief Description of Drawings

FIG. 1 is a drawing showing the constitution of a power amplifying apparatus 1 of an embodiment.
FIG. 2 is a drawing showing the power efficiency of a power amplifying apparatus using a Doherty amplifier.
FIG. 3 is a drawing showing an example of a table referenced by a central processing unit 21.
FIG. 4 is a drawing showing the power efficiency of the power amplifying apparatus 1.

### Description of Embodiments

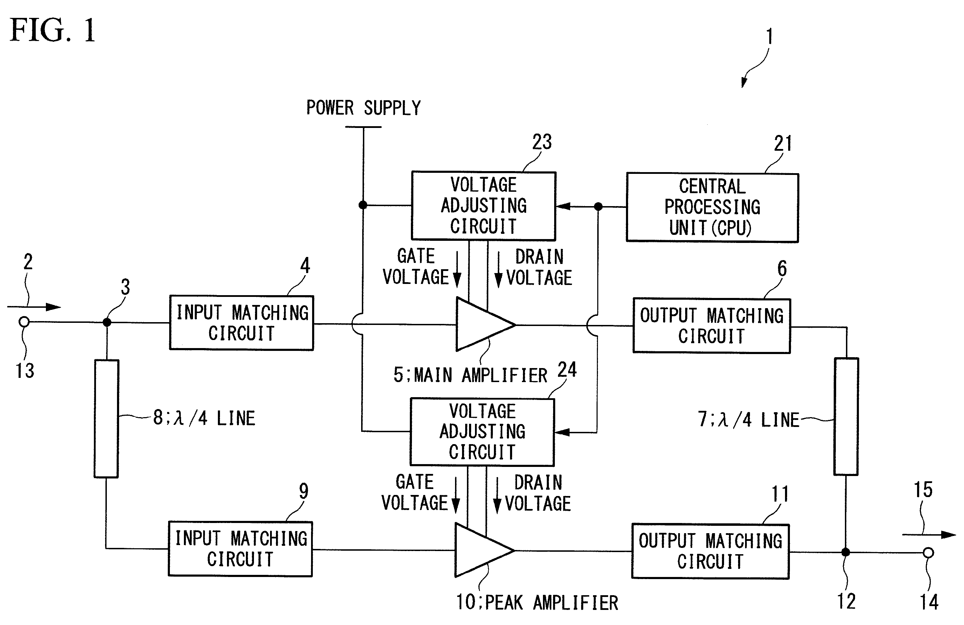

A power amplifying apparatus and a method for controlling a power amplifying apparatus of an embodiment will be described below, with references being made to the drawings. FIG. 1 shows the constitution of the power amplifying apparatus 1 of the embodiment. The power amplifying apparatus 1 shown in FIG. 1 includes an input matching circuit 4, a main amplifier 5, an output matching circuit 6, a λ/4 line 7, a λ/4 line 8, an input matching circuit 9, a peak amplifier 10, an output matching circuit 11, an input terminal 13, an output terminal 14, a central processing unit (CPU) 21, a voltage adjusting circuit 23 (voltage adjuster), and a voltage adjusting circuit 24 (voltage adjuster).

The input signal 2 input to the input terminal 13 passes through the branching point 3 and is input to the input matching circuit 4. The input matching circuit 4 matches the input signal 2 to the input of the amplifier element of the main amplifier 5. Because the amplifier element of the main amplifier 5 is biased at a level from a class A to class AB or B level, it outputs an amplified input signal 2, regardless of the power level of the input signal 2. The output matching circuit 6 matches the output of the amplifier element of the main amplifier 5 to the output of the main amplifier 5. The λ/4 line 7 acts as a circuit that impedance-converts the output of the main amplifier 5 when the input signal 2 is at a low power level.

The input signal 2 branched at the branching point 3 is delayed by 90 degrees in phase by the λ/4 line 8 and is input to the input matching circuit 9. The input matching circuit 9 matches the 90-degree phase-delayed input signal 2 to the input of the amplifier element of the peak amplifier 10. Because the amplifier element of the peak amplifier 10 is biased to a class C level, it is in a non-operating state when the input signal 2 is at a low power level and it is in an operating state, amplifies and outputs the input signal 2 when it is at a high power level. The output matching circuit 11 matches the output of the amplifier element of the peak amplifier 10 to the output of the peak amplifier 10. The output of the λ/4 line 7 and the output of the output matching circuit 11 are synthesized at the synthesis point 12. The signal synthesized at the synthesis point 12 is output from the output terminal 14 as the output signal 15.

In the input/output power characteristics of the power amplifying apparatus 1 constituted as noted above, linear power amplification is done by only the main amplifier 5 when the input power of the input signal 2 is below a prescribed input power level. In contrast, in the input/output power characteristics of the power amplifying apparatus 1, when the input power of the input signal 2 is above a prescribed input power level, in addition to the main amplifier 5, linear power amplification operation is done by the peak amplifier 10. This enables maintenance of the linearity of power amplification characteristics of the overall Doherty amplifier, even if the main amplifier 5 amplification characteristics saturate.

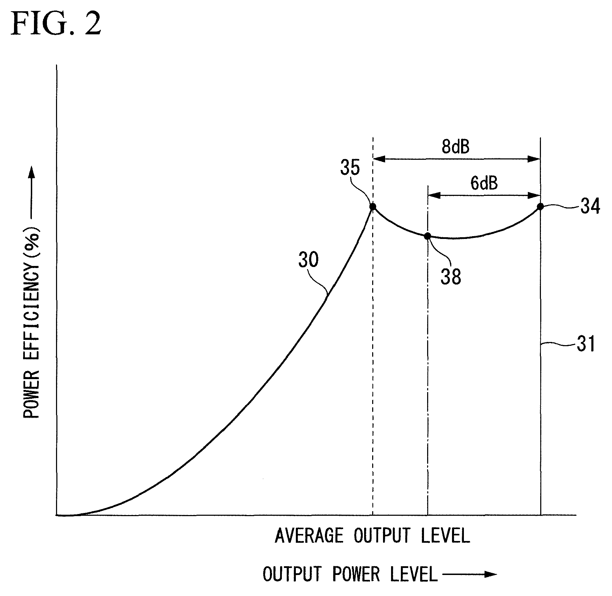

FIG. 2 shows the power efficiency of a power amplifying apparatus that uses a Doherty amplifier. In FIG. 2, the horizontal axis represents the output power level of the output signal 15, and the vertical axis represents the power efficiency. As shown in FIG. 2, when the output power level is the saturated output power level 31, the main amplifier 5 and the peak amplifier 10 are in the state in which they amplify at the saturated power level. In this case, the power efficiency 30 is at a peak. The point at which the power efficiency is at a peak will be taken as the saturation point 34.

In contrast, with the power amplifying apparatus 1, when the output power level of the output signal 15 is an output power level 8 dB lower than the saturated output power level 31 (PAR=8 dB), the state is that in which only the main amplifier 5 amplifies at the saturated power level, the peak amplifier 10 being in the state in which it does not amplify. In this case as well, the power efficiency 30 is at a peak. The point at which this power efficiency is at a peak will be taken as the transition point 35. In this manner, with the power amplifying apparatus 1 shown in FIG. 1, because there are two points, the saturation point 34 and the transition point 35, at which the power efficiency is at a peak, it is possible to increase the range of output power level over which the power efficiency is high.

In a power amplifying apparatus or the like used in a broadcast transmitter, when using a digitally modulated signal as the input signal 2, because the modulation scheme will be different, depending upon the region in which the power amplifying apparatus is installed, the PAR will change, depending upon the modulation scheme. There are cases in which a power amplifying apparatus is operated at a low efficiency, for example, if a power amplifier in which the PAR is set to 8 dB is operated at PAR=6 dB, in the state in which the power efficiency is lowered in direction of the arrow in FIG. 2, that is, at a point below the point at which the power efficiency is at a peak (for example, point 38 shown in FIG. 2).

Given this, a central processing unit 21, a voltage adjusting circuit 23, and voltage adjusting circuit 24 are provided in the power amplifying apparatus 1 shown in FIG. 1, so that the gate voltages and the drain voltages applied to each amplifier of the Doherty amplifier are adjusted to change the positions of the above-described saturation point and the transition point in the power efficiency, in accordance with the PAR and with the carrier frequency of the input signal.

Specifically, the central processing unit 21 determines information of the control voltages to be applied to the amplified element of the main amplifier 5 and to the amplifier element of the peak amplifier 10 by the voltage adjusting circuit 23 and the voltage adjusting circuit 24 (the gate voltage value and the drain voltage value) by, for example, referencing an internal table, in accordance with the PAR and the frequency band of the input signal.

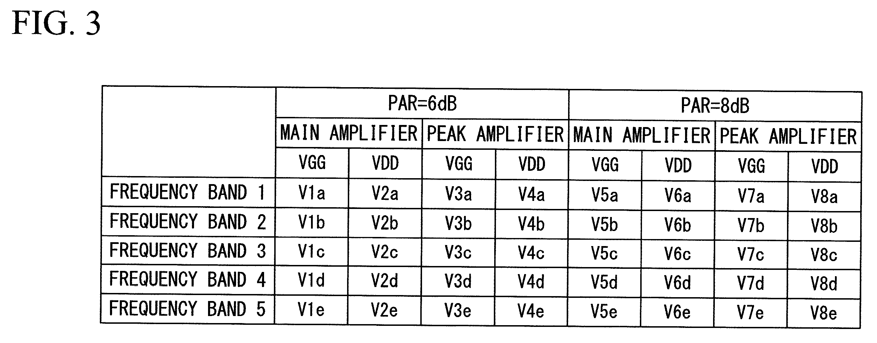

FIG. 3 shows an example of a table referenced by the central processing unit 21. This table stores, in association with the frequency band of the input signal 2 and the PAR of the power amplifying apparatus 1, voltage value information of the gate voltage VGG and drain voltage VDD to be applied to the main amplifier 5, and voltage value information of the gate voltage VGG and drain voltage VDD to be applied to the peak amplifier 10.

In the table shown in FIG. 3, five frequency bands, the frequency band 1 to the frequency band 5, are stored as carrier frequencies of the input signal 2 (of which, in the following, one frequency band will be referred to as the frequency band i).

For example, in the case in which the frequency of the input signal 2 is in the frequency band 1, for PAR=6 dB, V1a and V2a are stored, respectively, as the gate voltage VGG to be applied to the gate terminal of the main amplifier 5 and the drain voltage VDD to be applied to the drain terminal of the main amplifier 5 by the voltage adjusting circuit 23. Also, V3a and V4a are stored, respectively, as the gate voltage VGG to be applied to the gate terminal of the peak amplifier 10 and the drain voltage VDD to be applied to the drain terminal of the peak amplifier 10 by the voltage adjusting circuit 24.

When the frequency of the input signal 2 is in the frequency band 1, for PAR=8 dB, V5a and V6a are stored, respectively, as the gate voltage VGG to be applied to the gate terminal of the main amplifier 5 and the drain voltage VDD to be applied to the drain terminal of the main amplifier 5 by the voltage adjusting circuit 23. Also, V7a and V8a are stored, respectively, as the gate voltage VGG to be applied to the gate terminal of the peak amplifier 10 and the drain voltage VDD to be applied to the drain terminal of the peak amplifier 10 by the voltage adjusting circuit 24.

In this manner, the central processing unit references a table in which voltage value information of the drain voltages and the gate voltages is stored beforehand, in association with the frequency of the input signal 2 and the ratio between the saturated output power of the Doherty amplifier and the average output power of the Doherty amplifier (PAR), and determines respective sets of the drain voltages and the gate voltages to be supplied to the main amplifier 5 and to the peak amplifier 10 by the voltage adjusting circuits 23 and 24.

Although the table shown in FIG. 3 is shown for the PAR values of 6 dB and 8 dB, this table may be constituted to store the drain voltage and gate voltage information for another modulation scheme, that is, when the PAR values differ. For example, the table may be constituted to store the voltage information for the gate voltages and the drain voltages to be applied to the main amplifier 5 and the peak amplifier 10 for the case PAR=10 dB.

A set of control voltages stored in the table are determined in accordance with average output power obtained experimentally. For example, in this experiment, the power amplifying apparatus 1 is operated with an output monitor circuit connected to the output terminal 14, the gate voltages VGG and the drain voltages VDD applied to the main amplifier 5 and the peak amplifier 10 being varied, and the optimal control voltages (the gate voltages and drain voltages at which the power efficiency at the transition point is a peak) are determined while observing the power efficiency and saturated output power at the average output power. This experiment also determines the gate voltages VGG and the drain voltages VDD stored in the table shown in FIG. 3 in accordance with the carrier frequency of the input signal 2 and the PAR value. This experiment, for example, by being conducted after the manufacture of the power amplifying apparatus 1, stores the various control voltages in a table, in association with the frequency band of the input signal 2 and the PAR. The reason for determining each control voltage in accordance with the frequency band of the input signal 2 is that the peaks at the saturation point and transition point differ depending upon the frequency of the input signal 2. By determining the control voltages in association with the frequency band of the input signal 2 in this manner, it is possible to operate the power amplifying apparatus 1 with the average output power in a state in which the power efficiency is optimum (in which the efficiency is the highest) in accordance with the carrier frequency of the input signal 2 and the PAR.

Which set of the control voltages stored in the table to use in accordance with a PAR is determined by the manufacturer at the time of shipping the power amplifying apparatus 1, by inputting from an input device provided with respect to, for example, the central processing unit 2 a signal, indicating with what modulation scheme operation is to be done. By doing this, the central processing unit 21 stores the PAR input by the manufacturer from the table and reads out control voltages associated with the PAR. In regions having the same modulation scheme, if operation is to be done with a changed frequency band of the input signal 2, for example, the installer of the power amplifying apparatus inputs a signal indicating in what frequency band operation is to be done, from an input device provided with respect to the central processing unit 21. By doing this, the central processing unit 21 stores the frequency band input by the installer from the table and reads out control voltages associated with the frequency band.

Returning to FIG. 1, the voltage adjusting circuit 23 converts the voltage level of the supplied power supply to the levels of control voltages determined by the central processing unit 21 and applies the converted gate voltage and drain voltage to the gate terminal and drain terminal, respectively, of the amplifier element of the main amplifier 5.

The voltage adjusting circuit 24 converts the voltage level of the drain power supply to the levels of control voltage determined by the central processing unit 21 and applies the converted voltages (control voltages) to the gate terminal and drain terminal of the amplifier element of the peak amplifier 10. In this manner, in the power amplifying apparatus 1 of the embodiment, the gate voltages and the drain voltages of the main amplifier 5 and the peak amplifier 10 can be set independently, in accordance with the average output power level of the output signal 15.

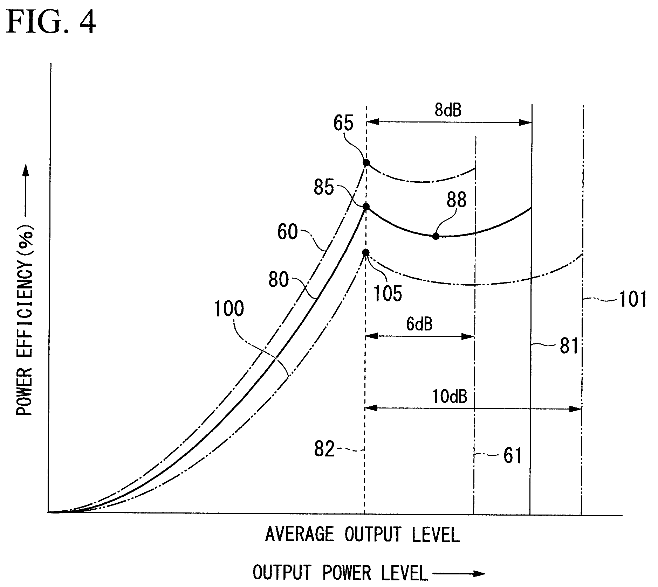

Continuing, operation of the power amplifying apparatus 1 in accordance with the modulation scheme will be described, with reference made to the drawings. FIG. 4 shows the power efficiency of the power amplifying apparatus 1 shown in FIG. 1. In FIG. 4, the horizontal axis represents the output power level of the output signal 15, and the vertical axis represents the power efficiency.

Of the power efficiencies shown in FIG. 4, the power efficiency 80 indicated by a solid line is for the power efficiency of the power amplifying apparatus 1 at PAR=8 dB. When operation is done at PAR=8 dB, the central processing unit 21 reads from a plurality of sets of control voltages stored in the table a set of control voltage values (the VGG and VDD to be applied to the main amplifier, and the VGG and VDD to be applied to the peak amplifier) associated with PAR=8 dB. For example, in the case of a carrier frequency of the input signal 2 in the frequency band 1, of the set of control voltage values associated with the frequency band 1, the gate voltage value V5a and drain voltage value V6a to be applied to the main amplifier 5 and the gate voltage value V7a and drain voltage value V8a to be applied to the peak amplifier 10 associated with PAR=8 dB are read from the table.

The central processing unit 21 performs a control of the voltage adjusting circuits 23 and 24 to apply gate voltages and drain voltages corresponding to these voltage values to the main amplifier 5 and to the peak amplifier 10. With these control voltages applied, because the drain voltages and the gate voltages are applied to the main amplifier 5 and the peak amplifier 10 separately, the power efficiency of the power amplifying apparatus 1 is as shown by the power efficiency 80 in FIG. 4. In the power efficiency 80, at a point reduced by an 8-dB back-off from the saturated output power level 81, there is a transition point 85 at which the power efficiency 80 reaches a peak. Because this transition point 85 is the average output power level 82 for PAR=8 dB in the power amplifying apparatus 1, high-efficiency operation is possible at the average output power level 82. That is, in a region using a modulation scheme with PAR=8 dB, the power amplifying apparatus 1 can amplify an input signal 2 in the frequency band 1 with high efficiency, while the transition point 85 at which the power efficiency is a peak taken as the average output power.

If the power amplifying apparatus 1 is operated in a region having a different modulation scheme, for example, with PAR=6 dB, the central processing unit 21 reads from a plurality of sets of control voltages stored in the table a set of control voltages (the VGG and VDD to be applied to the main amplifier, and the VGG and VDD to be applied to the peak amplifier) associated with PAR=6 dB. For example, when a carrier frequency of the input signal 2 is in the frequency band 1, of the set of control voltage values associated with the frequency band 1, the gate voltage value V1a and drain voltage value V2a to be applied to the main amplifier 5 and the gate voltage value V3a and drain voltage value V4a to be applied to the peak amplifier 10 associated with PAR=6 dB are read from the table.

The central processing unit 21 performs a control of the voltage adjusting circuits 23 and 24 to apply the gate voltages and drain voltages corresponding to these voltage values to the main amplifier 5 and to the peak amplifier 10. With these control voltages applied, because the drain voltages and the gate voltages are applied to the main amplifier 5 and the peak amplifier 10 separately, the power efficiency of the power amplifying apparatus 1 is as shown by the power efficiency 60 in FIG. 4. In the power efficiency 60, at a point reduced by a 6-dB back-off from the saturated output power level 61, there is a transition point 65 at which the power efficiency 60 reaches a peak. Because this transition point 65 is the average output power level 82 for PAR=6 dB in the power amplifying apparatus 1, high-efficiency operation is possible at the average output power level 82. That is, in a region having a modulation scheme with PAR=6 dB, the power amplifying apparatus 1 can amplify an input signal 2 in the frequency band 1 with high efficiency, while the transition point 65 at which the power efficiency is a peak taken as the average output power.

For example, depending on the modulation scheme, if a power amplifying apparatus set for PAR=8 dB and not having a constitution wherein the gate voltages and drain voltages are applied to the main amplifier 5 and the peak amplifier 10 separately is operated at PAR=6 dB, it will operate in the vicinity of the point 88 in the power efficiency 80 of PAR=8dB. As a result, the power amplifying apparatus will operate in a state having low power efficiency.

In contrast, with the power amplifying apparatus 1 of the embodiment, the power efficiency in a reduction operation, as described above, is the power efficiency 60 shown in FIG. 4. For this reason, operation is possible with the output power level at the transition point 65 as the average output power level, and amplification with high power efficiency, that is, at high efficiency, can be done.

If the power amplifying apparatus 1 is operated in a region having a different modulation scheme, for example, operated with PAR=10 dB, the central processing unit 21 reads out one set of control voltage values associated with the PAR=10 dB (the VGG and VDD to be applied to the main amplifier and the VGG and VDD to be applied to the peak amplifier) from the plurality of sets of control voltages stored in the table. For example, when the carrier frequency of the input signal 2 is in the frequency band 1, of the set of control voltage values associated with the frequency band 1, the gate voltage value and drain voltage value to be applied to the main amplifier 5 and the gate voltage value and drain voltage value to be applied to the peak amplifier 10 associated with PAR=10 dB are read from the table.

The central processing unit 21 performs a control of the voltage adjusting circuits 23 and 24 to apply the gate voltages and drain voltages corresponding to these voltage values to the main amplifier 5 and to the peak amplifier 10. With these control voltages applied, because the drain voltages and the gate voltages are applied to the main amplifier 5 and the peak amplifier 10 separately, the power efficiency of the power amplifying apparatus 1 is as shown by the power efficiency 100 in FIG. 4. In the power efficiency 100, at a point reduced by a 10-dB back-off from the saturated output power level 101, there is a transition point 105 at which the power efficiency 100 reaches a peak. Because this transition point 105 is the average output power level 82 for PAR=10 dB in the power amplifying apparatus 1, high-efficiency operation is possible at the average output power level 82. That is, in a region having a modulation scheme with PAR=10 dB, the power amplifying apparatus 1 can amplify with the input signal 2 in the frequency band 1 with high efficiency, while the transition point 105 at which the power efficiency is a peak taken as the average output power.

In a region in which PAR=8 dB, if the carrier frequency of the input signal 2 is in the frequency band 2, of the sets of control voltage values associated with the frequency band 2, the gate voltage value V5a and drain voltage value V6b to be applied to the main amplifier 5 and the gate voltage value V7b and drain voltage value V8b to be applied to the peak amplifier 10 associated with PAR=8 dB are read from the table.

The central processing unit 21 performs a control of the voltage adjusting circuits 23 and 24 to apply the gate voltages and drain voltages corresponding to these voltage values to the main amplifier 5 and to the peak amplifier 10. With these control voltages applied, because the drain voltages and the gate voltages are applied to the main amplifier 5 and the peak amplifier 10 separately, in the power efficiency of the power amplifier apparatus 1, in accordance with the carrier frequency of the input signal 2, at a point reduced by a 8-dB back-off from the saturated output power level 81, there is a transition point at which the power efficiency reaches a peak. Because this transition point is the average output power level for PAR=8 dB in the power amplifying apparatus 1, high-efficiency operation is possible at this average output power level. That is, in a region using a prescribed modulation scheme, the power amplifying apparatus 1 can amplify the input signal 2 in an arbitrary frequency band with high efficiency, while the transition point at which the power efficiency is a peak taken as the average output power.

At least one above-described embodiment provides a power amplifying apparatus and a method for controlling a power amplifying apparatus, wherein a central processing unit perform, based on the ratio between the saturated output power of a Doherty amplifier and the average output power of a Doherty amplifier, a control of voltage adjusters to supply drain voltages and gate voltages to each of a main amplifier and a peak amplifier, thereby maintaining a high power efficiency, even when amplifying input signals having different modulation schemes.

While certain embodiments of the present invention have been described, these embodiments have been presented by way of example only, and are not intended to limit the scope of the inventions. These embodiments may be embodied in a variety of other forms, and various omissions, substitutions and changes in the form of the embodiments may be made without departing from the spirit of the inventions. The claims and their equivalents are intended to cover such embodiments or modifications as would fall within the scope and spirit of the invention.

## Claims

1. A power amplifying apparatus comprising:
a Doherty amplifier configured to amplify an input signal using a main amplifier and a peak amplifier and to output an output signal in which the amplified signals are synthesized;
a voltage adjuster configured to supply drain voltages and gate voltages to the main amplifier and the peak amplifier; and
a central processing unit configured to perform, based on a ratio between a saturated output power and an average output power of the Doherty amplifier, a control of the voltage adjuster to supply the drain voltages and the gate voltages.

2. The power amplifying apparatus according to claim 1,
wherein the central processing unit is configured to
reference a table that stores voltage value information of the drain voltages and the gate voltages, where the drain voltages and the gate voltages are associated with frequencies of the input signal and with ratios between the saturated output power and the average output power of the Doherty amplifier, and
determine respective sets of the drain voltages and the gate voltages to be supplied to the main amplifier and the peak amplifier by the voltage adjuster.

3. A method for controlling a power amplifying apparatus including a Doherty amplifier configured to amplify an input signal using a main amplifier and a peak amplifier and to output an output signal in which the amplified signals are synthesized;
a voltage adjuster configured to supply drain voltages and gate voltages as control voltages to the main amplifier and the peak amplifier; and
a central processing unit configured to perform a control of the voltage adjuster to supply the drain voltages and the gate voltages,
the method for controlling the power supplying apparatus comprising:
the central processing unit determining, based on a ratio between a saturated output power of and an average output power of the Doherty amplifier, respective sets of the drain voltages and the gate voltages, and
the central processing unit performing a control of the voltage adjuster based on the determined drain voltages and gate voltages.
